# EUROPÄISCHE PATENTANMELDUNG

(11) **EP 1 391 868 A1**
(43) Veröffentlichungstag der Anmeldung: **25.02.2004**
(21) Anmeldenummer: 02090299.5
(22) Anmeldetag: 23.08.2002
(51) Int. Cl.: G09G 3/32

(54) **Verfahren und Vorrichtung zur Ansteuerung einer emissiv-reemissiven Aktiv-Matrix-Anzeige**

(71) Anmelder: Samsung SDI Co. Ltd., Suwon-shi, Kyonggi-do (KR)
(72) Erfinder: Fischer, Joerg, 10243 Berlin (DE); Redecker, Michael Dr., 12524 Berlin (DE)
(74) Vertreter: Hengelhaupt, Jürgen D., Dipl.-Ing.

(57) **Zusammenfassung**

Die Erfindung betrifft ein Verfahren und eine Vorrichtung zur Ansteuerung eines Aktiv-Matrix-Displays aus Photolumineszenz-Löschungs-Elementen (PQD).

Der vorliegenden Erfindung liegt die Aufgabe zugrunde, eine Ansteuerschaltung für PQD-Displays anzugeben, die geringere Steuerströme als die bekannten Schaltungen benötigt und darüber hinaus sowohl einen emissiven als auch einen reemissiven Betrieb von PQD ermöglicht.

Dazu werden PQD, die sowohl im emissiven Modus zur Umwandlung von Signalspannungen in Licht als auch im reemissiven Modus zur Unterdrückung einer Photolumineszenzemission schaltbar sind, derart mit Pixel-Graustufeninformationen in Form von Signalspannungen selektiv adressiert, dass die Signalspannung im emissiven Modus eine Spannung in Durchlassrichtung des PQD und im reemissiven Modus eine Spannung in Sperrrichtung des PQD steuert und diese Spannung wird bis zu einer nächsten selektiven Adressierung am PQD konstant gehalten.

## Beschreibung

Die Erfindung betrifft ein Verfahren und eine Vorrichtung zur Ansteuerung eines Aktiv-Matrix-Displays aus Photolumineszenz-Löschungs-Elementen, auch sog. Photoluminescence Quenching Device(PQD).

Flachdisplays auf der Basis organischer Leuchtdioden (OLEDs) zeichnen sich durch hohe Brillianz und weiten Betrachtungswinkel aus. Als selbstemissive Technologie benötigen OLED-Displays keine Hintergrundbeleuchtung und können damit unter Bedingungen mit niedrigem bis mittlerem Umgebungslichtanteil energetisch vorteilhaft eingesetzt werden.
Unter Bedingungen mit einem hohem Anteil an Umgebungslicht, z.B. in direktem Sonnenlicht, muß jedoch überproportional viel Leistung aufgewendet werden, um die benötigte Helligkeit zu erreichen. Zudem sind die benötigten Ströme für die Ansteuerung der emissiven Bauelemente entsprechend hoch. Daher sind bei einem hohen Umgebungslichtanteil reflektive und reemissive Technologien, wie zum Beispiel Flüssigkristallanzeigen überlegen. Deren Nachteil besteht jedoch darin, dass sie für die Operation unter Bedingungen mit wenig Umgebungslicht eine Hintergrundbeleuchtung (Backlight) benötigen, durch welche sich die baulichen Ausmaße und die Energieaufnahme bei geringem Umgebungslichtanteil überproportional erhöhen.

Bauelemente, die auf der Basis organischer Leuchtdioden sowohl im emissiven als auch im reemissiven Modus betrieben werden können, sind aus DE 10042974 A1 bekannt. Ein solches Photolumineszenzanzeigeelement (PQD, Photoluminescence Quenching Device) hat die Struktur ähnlich einer organischen Leuchtdiode und kann im selbstemissiven Modus, d.h. ohne Umgebungslicht, aber auch im reemissiven Modus betrieben werden. Im reemissiven Modus wird die Intensität des Photolumineszenzlichts durch das Anlegen einer Spannung in Sperrrichtung des PQD gesteuert. Bei entsprechender Wahl der Kontakt- und Emittermaterialien läßt sich mit den oben beschriebenen Bauelementen der Betrieb sowohl im emissiven als auch im reemissiven (Photolumineszenzlöschungs-) Modus, der sog. duale Betrieb, realisieren. Vorteilhafterweise wird hierfür kein Backlight benötigt. Voraussetzung für den reemissiven Betrieb ist, dass ausreichend Umgebungslicht absorbiert werden kann. Außerdem ist es erforderlich, sowohl negative als auch positive Steuerspannungen für das Anzeigeelement bereitzustellen.

Aktiv-Matrix-Treiberschaltungen auf der Basis amorphen und polykristallinen Siliziums stellen den Stand der Technik dar. Für die Ansteuerung von organischen Leuchtdioden (OLED) sind Treiberschaltungen aus US 006157356 (IBM), US 005952789 (Sarnoff Corp.) und WO 99/43028 (CDT) bekannt.
Sämtliche der bekannten Ansteuerschaltungen haben den Nachteil, dass sie lediglich den emissiven Betrieb von OLED realisieren können. Dadurch sind bei einem hohen Umgebungslichtanteil die benötigten Ströme für die Ansteuerung der emissiven Bauelemente und dadurch die Ansprüche an die Ansteuerschaltung hoch. Dies führt insbesondere zu einer kostenintensiven Fertigung, die den durch die OLED-Technologie gewonnenen Kostenvorteil verringert.

Der vorliegenden Erfindung liegt daher die Aufgabe zugrunde, eine Ansteuerschaltung für PQD-Displays anzugeben, die geringere Steuerströme als die bekannten Schaltungen benötigt und darüber hinaus sowohl einen emissiven als auch einen reemissiven Betrieb von PQD ermöglicht.

Diese Aufgabe wird erfindungsgemäß gelöst durch die Merkmale im kennzeichnenden Teil des Anspruchs 1 (Verfahrensanspruch) und des Anspruchs 8 (Vorrichtungsanspruch) im Zusammenwirken mit den Merkmalen im Oberbegriff. Zweckmäßige Ausgestaltungen der Erfindung sind in den Unteransprüchen enthalten.

Ein besonderer Vorteil der Erfindung besteht darin, dass mit dem erfindungsgemäßen Verfahren und der erfindungsgemäßen Ansteuerschaltung PQD-Displays betrieben werden können, die bei ausreichender Helligkeit nur niedrige Steuerströme benötigen. Dadurch wird die Energieaufnahme erheblich verringert.

Dazu werden PQD, die sowohl im emissiven Modus zur Umwandlung von Signalspannungen in Licht als auch im reemissiven Modus zur Unterdrückung einer Photolumineszenzemission schaltbar sind, derart mit Pixel-Graustufeninformationen in Form von Signalspannungen selektiv adressiert, dass die Signalspannung im emissiven Modus eine Spannung in Durchlassrichtung der PQD und im reemissiven Modus eine Spannung in Sperrrichtung der PQD steuert und diese Spannung wird bis zu einer nächsten selektiven Adressierung am PQD konstant gehalten.

Dies kann durch eine Schaltung aus zwei selbstsperrenden p-Kanal Dünnfilm-Polysilizium-Feldeffekttransistoren und einem Kondensator realisiert werden, wobei die Aktivierungsleitung mit dem Gate des Aktivierungstransistors und die Datenleitung mit der Source des Aktivierungstransistors verbunden ist, das Gate des Treibertransistors mit dem Drain des Aktivierungstransistors, die Source des Treibertransistors mit dem Versorgungsspannungsanschluss verbunden ist und das PQD mit dem Drain des Treibertransistors und der Kathode verbunden ist, wobei ein Speicherkondensator über Gate und Source des Treibertransistors liegt, wobei für den emissiven Betrieb die Aktivierungsleitungsspannung kleiner ist als die Datenspannung und für den reemissiven Betrieb die Aktivierungsleitungsspannung größer ist als die Datenspannung.

Ein weiterer Vorteil ist, dass mit der erfindungsgemäßen Ansteuerschaltung PQD-Displays ohne die Verwendung eines Backlights auch bei einem hohen Umgebungslichtanteil energetisch vorteilhaft betrieben werden können.

Die Erfindung soll nachstehend anhand von zumindest teilweise in den Figuren dargestellten Ausführungsbeispielen näher erläutert werden.

Es zeigen:
- Fig. 1:: eine schematische Darstellung eines PQD,
- Fig. 2a:: eine Darstellung eines PQD im emissiven Betrieb,
- Fig. 2b:: eine Darstellung eines PQD im reemissiven Betrieb,
- Fig. 3:: den prinzipiellen Aufbau einer erfindungsgemäßen Ansteuerschaltung für ein einzelnes PQD,
- Fig. 4:: den prinzipiellen Aufbau einer erfindungsgemäßen Ansteuerschaltung für eine 3x3- PQD-Matrix,
- Fig. 5:: eine Darstellung eines detaillierten Blockschaltbildes eines Displayelements,
- Fig. 6:: den Aufbau einer bevorzugten Ansteuerschaltung mit selbstsperrenden p-Kanal Dünnfilm-Polysilizium-Feldeffekttransistoren,
- Fig. 7:: ein Display mit einer internen Aktivierungs-/Zeilentreiberschaltung und einer internen Daten-/Spaltentreiberschaltung,
- Fig. 8:: ein Display mit einer externen Aktivierungs-/Zeilentreiberschaltung und einer externen Daten-/Spaltentreiberschaltung,
- Fig. 9:: ein schematische Darstellung der in der Ansteuerschaltung möglichen Spannungspegel,
- Fig. 10:: eine schematische Darstellung der Spannungspegel beim emissiven Betrieb,
- Fig. 11:: eine schematische Darstellung der Spannungspegel beim reemissiven Betrieb,

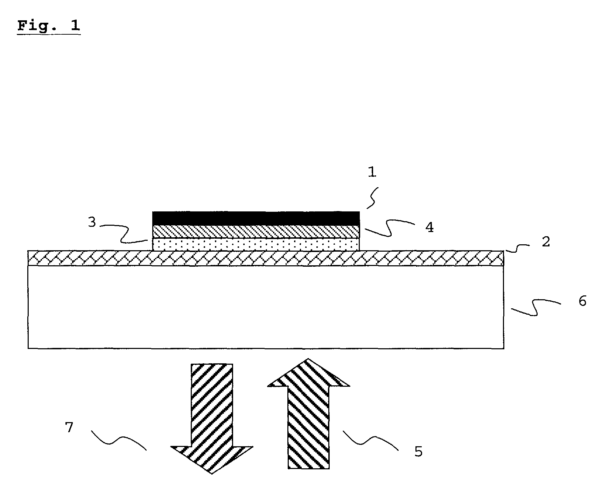

Der Aufbau eines Photolumineszenzanzeigeelementes (PQD) kann gemäß Fig. 1 erfolgen.
Auf einem Substrat 6 wird eine lichtdurchlässige Anode 2 angeordnet. Darauf befindet sich eine Lochinjektionsschicht 3, auf welcher ein Emittermaterial 4 aufgebracht wird. Auf das Emittermaterial 4 wird eine Kathode 1 aufgebracht. Werden polymere Materialien für den Lochleiter sowie die Emitterschicht verwendet, so können für die Lochleiterschicht Dispersionen von Poly(ethylendioxythiophen)/ Polystyrolsulfonsäure und Polyanilin durch Aufschleudern, Aufsprühen, Aufrakeln und durch Tintenstrahldrucken aufgebracht werden.
Die Emitterpolymere, speziell aus den Materialklassen der Polyphenylenvinylene und der Polyfluorene, können ebenfalls durch Aufschleudern, Aufsprühen, Aufrakeln und durch Tintenstrahldrucken aufgebracht werden.
Werden niedermolekulare Materialien für die aktiven Schichten verwendet, so können diese gemäß dem Stand der Technik durch Vakuumabscheidung aufgebracht und durch eine Schattenmaske strukturiert werden.

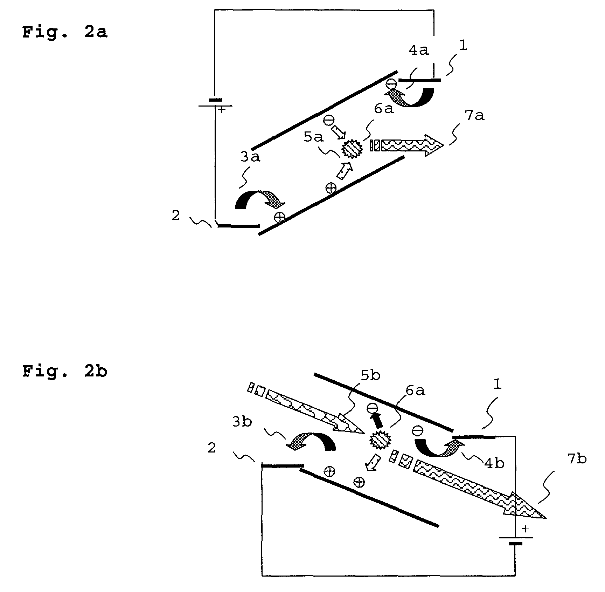

Zum emissiven Betrieb eines PQD entsprechend Fig. 2 werden Ladungsträger in das Anzeigeelement injiziert, die unter Lichtaussendung 7 rekombinieren. Die Löcher (Defektelektronen) werden über die Anode 2, typischerweise Indium-Zinnoxid (ITO), injiziert. Auf der Gegenseite sorgt die negativ gepolte Kathode 1, typischerweise ein unedles Metall wie Kalzium oder Aluminium, für die Injektion von Elektronen. Die Kathode kann weitere Isolierschichten anorganischer Materialien enthalten, die ein optimales Ladungsinjektions- und Sperrverhalten garantieren. Eine Stromquelle wird mit der Anode 2 und der Kathode 1 verbunden. Ein Stromfluß führt dann zu einer Lichtemission des elektrolumineszierenden Materials. Das PQD ist in diesem Betriebsmodus in Durchlassrichtung geschaltet.

Im reemissiven Modus entsprechend Fig. 2b wird das Umgebungslicht in der Emitterschicht des PQD in Photolumineszenzlicht umgewandelt, das wieder abgestrahlt wird. Die Anzeigeelemente werden dabei im sogenannten Photolumineszenz-Löschungsmodus betrieben. Die Funktionsweise des Photolumineszenz-Löschungsmodus beruht auf dem Effekt, daß die Photolumineszenzemission eines organischen Materials durch ein angelegtes elektrisches Feld unterdrückt werden kann. In einem ersten Schritt wird das Emittermaterial durch eine externe Lichtquelle optisch angeregt. Es bilden sich angeregte Zustände, die typischerweise nach einer Zeit von wenigen Nanosekunden unter Aussendung von Photolumineszenzlicht zerfallen. Das dabei ausgesandte Licht besitzt eine Farbe, die für das jeweilige Emittermaterial charakteristisch ist. Durch Anlegen einer zusätzlichen Spannung kann ein elektrisches Feld in dem Emittermaterial erzeugt werden. Dieses Feld bewirkt die teilweise Aufspaltung der angeregten Zustände in Ladungsträger, bevor Photolumineszenzstrahlung emittiert werden kann. Dadurch wird die Konzentration angeregter Zustände herabgesetzt und als Konsequenz daraus die Intensität des Photolumineszenzlichtes verringert. Somit besteht die Möglichkeit, die Intensität der Photolumineszenzstrahlung durch die angelegte Spannung zu steuern. Ohne angelegte Spannung ist die Intensität am höchsten, während sie unter angelegter Spannung reduziert wird. In Bezug auf die Quanteneffizienz hat der Photolumineszenzlöschungsmodus deutliche Vorteile. So wird pro gelöschter Anregung nur ein Ladungsträgerpaar erzeugt, das über die Kontakte abfliessen muss. Der erforderliche Steuerstrom, der durch eine geeignete Ansteuerschaltung bereitgestellt werden muss, kann damit klein gehalten werden.

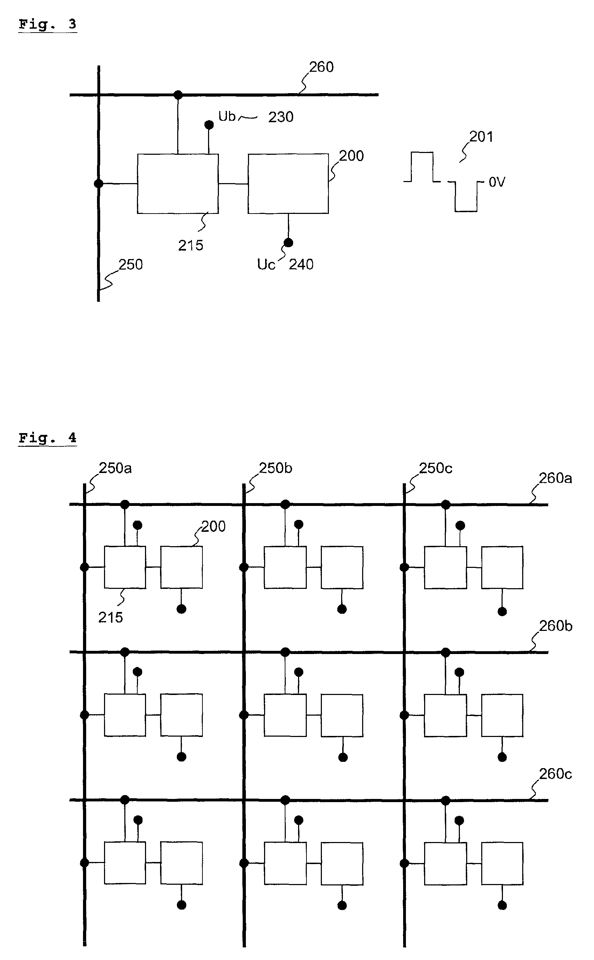

Fig. 3 zeigt schematisch die erfindungsgemäße Ansteuerung für ein einzelnes PQD. Eine Ansteuerschaltung 215 ist an eine Aktivierungsleitung 260 und an eine Datenleitung 250 angeschlossen. Das PQD 200 ist mit der Ansteuerschaltung 215 verbunden und besitzt einen Versorgungsspannungsanschluß 230 und einen Kathodenanschluss 240.

Bei einem Zeilenabtastvorgang wird durch das Anlegen einer geeigneten Spannung an die Aktivierungsleitung 260 beim Anliegen einer geeigneten Datenspannung an der Datenleitung 250 eine an Daten- und Aktivierungsleitung angeschlossene elektronische Ansteuerschaltung 215 dazu veranlasst, eine positive Spannung (zwischen Anode und Kathode) für eine Emission oder eine negative Spannung (zwischen Anode und Kathode) für eine Photolumineszenzlöschung für das Anzeigeelement 200 bereitzustellen. Dazu ist es erforderlich, dass eine bestimmte Kathodenspannung 240 und eine bestimmte Versorgungsspannung 230 dauerhaft bis zum nächsten Zeilenabtastvorgang anliegt. Das Diagramm 201 zeigt die Spannung zwischen Anode und Kathode des PQD, und verdeutlicht schematisch die für das PQD notwendige positive Spannung (zwischen Anode und Kathode) für die Emission und die erforderliche negative Spannung (zwischen Anode und Kathode) für den remissiven Betrieb.

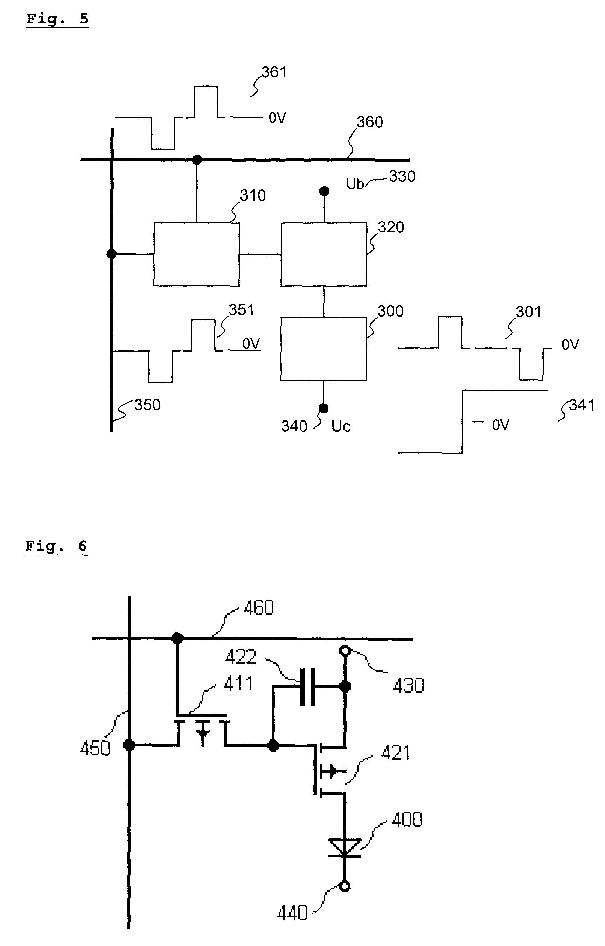

Durch das Zusammenschalten vom mehreren oben beschriebenen Schaltungen mit N Zeilen und M Spalten ergibt sich eine Anzeigematrix mit N*M Anzeigeelementen. Fig. 4 zeigt eine Anzeigematrix mit 3*3=9 Anzeigeelementen. Von den Aktivierungsleitungen 260a, 260b und 260c wird jeweils eine Leitung während eines Zeilenabtastzyklusses sequentiell aktiviert, um Bildinformationen in die einzelnen PQD 200 über die Ansteuerschaltungen 215 zu programmieren. Während eines Zeilenabtastzyklusses müssen an den Datenleitungen 250a, 250b, 250c die zu programmierenden Steuerspannungen anliegen. Durch ein stetiges, wiederholendes schnelles Abtasten aller Zeilen können Videoinformationen auf dem Display dargestellt werden.

Fig. 5 zeigt ein detailliertes Blockschaltbild eines bevorzugten Ausführungsbeispiels einer Ansteuerschaltung für ein Displayelement. Eine Aktivierungsschaltung 310 ist an eine Aktivierungsleitung 360 und an eine Datenleitung 350 angeschlossen. Die Treiberschaltung 320 ist mit der Aktivierungsschaltung 310 und dem PQD 300 verbunden und besitzt einen Versorgungsspannungsanschluß 330. Das PQD 300 besitzt einen Kathodenanschluss 340. Die im folgenden beschriebenen Spannungen sind, sofern nicht anders angegeben, Spannungspotentiale zwischen dem jeweils angegebenen Punkt und dem Bezugspunkt 330 (Versorgungsspannungsanschluß Ub). An den Versorgungsspannungsanschluß 330 werden 0 Volt angelegt. Die Diagramme 301, 341, 351, 361 verdeutlichen schematisch die verschiedenen notwendigen Spannungen für den emissiven und remissiven Betrieb des Displayelements (Pixel).
Je nach Polarität der Kathodenspannung 340 kann bei negativer Spannung ein emissiver oder bei positiver Spannung ein remissiver Betrieb des PQD 300 erfolgen.

Beim Anliegen einer negativen Spannung am Kathodenanschluß 340 des PQD wird bei einem Zeilenabtastvorgang durch das Anlegen einer negativen Spannung an die Aktivierungsleitung 360 durch eine an der Aktivierungsleitung 360 angeschlossenen Aktivierungsschaltung 310 die Treiberschaltung 320 dazu veranlasst, beim Anliegen einer negativen Datenspannung an der Datenleitung 350 eine positive Spannung (zwischen Anode und Kathode) für eine Emission des PQD 300 bereitzustellen und somit ein helles Pixel erscheinen zu lassen. Liegt anstelle der negativen Spannung eine "Null"-Spannung an der Datenleitung 350 während des Abtastvorgangs an, werden Null Volt am PQD 300 (zwischen Anode und Kathode) bereitgestellt und es erscheint ein dunkles Pixel.
Wird die Aktivierungsschaltung 310 durch das Anlegen einer "Null"-Spannung deaktiviert, bleibt die Spannung am Photolumineszenzanzeigeelement, unabhängig von der Spannung an der Datenleitung 350 bis zum nächsten Zeilenabtastvorgang konstant.

Der remissive Betrieb setzt das Vorhandensein von für die Photolumineszenz notwendigem Umgebungslicht voraus. Beim Anliegen einer positiven Spannung am Kathodenanschluß des PQD 340 wird bei einem Zeilenabtastvorgang durch das Anlegen einer "Null"-Spannung an die Aktivierungsleitung 360 durch eine an der Aktivierungsleitung 360 angeschlossenen Aktivierungsschaltung 310 die Treiberschaltung 320 dazu veranlasst, beim Anliegen einer "Null"-Datenspannung an der Datenleitung 350 eine negative Spannung (zwischen Anode und Kathode) für eine Photolumineszenzlöschung für das PQD 300 bereitzustellen und es somit als dunkles Pixel erscheinen zu lassen. Liegt anstelle der "Null"-Spannung eine positive Spannung an der Datenleitung 350 während des Abtastvorgangs an, werden Null Volt am Anzeigeelement 300 (zwischen Anode und Kathode) bereitgestellt es erscheint ein helles Pixel durch Photolumineszenz.
Wird die Aktivierungsschaltung 310 durch das Anlegen einer positiven Spannung deaktiviert, bleibt die Spannung am Photolumineszenzanzeigeelement, unabhängig von der Spannung an der Datenleitung 350 bis zum nächsten Zeilenabtastvorgang konstant.

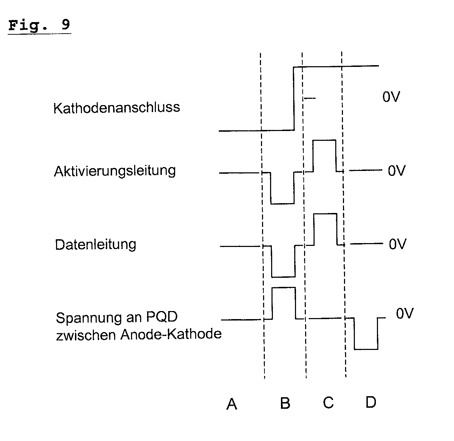

Fig. 9 zeigt die schematischen Spannungspegeldiagramme der Schaltung eines Displayelementes entsprechend Fig. 5. Alle Spannungspegel beziehen auf den Versorgungsspannungsanschluß 330. An den Versorgungsspannungsanschluß 330 werden 0 Volt angelegt. Im Bereich A und B ist ein emissiver Betrieb, im Bereich C und D ist ein remissiver Betrieb möglich.

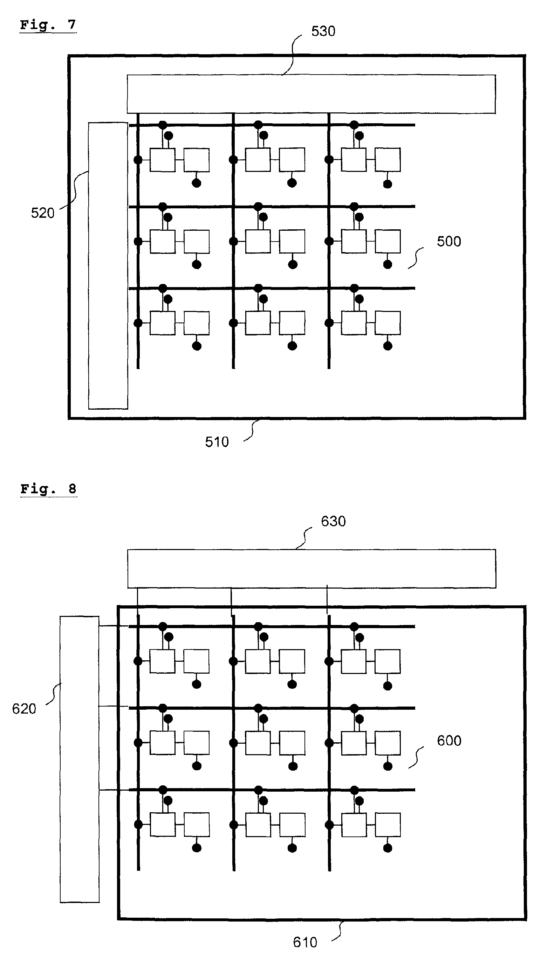

Da eine Abhängigkeit der Helligkeit von der am PQD anliegenden positiven Spannung im Emissionsbetrieb sowie eine Abhängigkeit der Helligkeit des Photolumineszenzlichtes von der am PQD anliegenden negativen Spannung besteht, ist durch eine Variation der steuernden Spannung (Datenspannung) eine Steuerung der Grauwerte der Anzeigeelemente möglich. Somit kann eine Graustufendarstellung für ein Display erreicht werden. Das Bereitstellen der für den Anzeigenbetrieb notwendigen Datenspannungen und Aktivierungsspannungen kann sowohl durch externe elektronische Schaltungen entsprechend Fig. 8 als auch durch interne, auf dem Anzeigesubstrat befindliche elektronische Schaltungen entsprechend Fig. 7 realisiert werden.

In einem besonders bevorzugten Ausführungsbeispiel wurde die geforderte Bifunktionalität der Ansteuerschaltung mit Hilfe einer aktiven Treibermatrix auf der Basis von Dünnfilm-Polysilizium-Feldeffekttransistoren realisiert.
Fig. 6 zeigt den Aufbau einer geeigneten Schaltung mit selbstsperrenden p-Kanal Dünnfilm-Polysilizium-Feldeffekttransistoren. Die Schaltung ist aus zwei Transistoren aufgebaut. An die Aktivierungsleitung 460 ist das Gate eines Aktivierungstransistors 411 angeschlossen. Der Sourceanschluss des Aktivierungstransistors 411 ist mit der Datenleitung 450 verbunden. Ein zweiter Transistor 421 dient als Treibertransistor. Er stellt die notwendigen Spannungen für den emissiven und remissiven Modus bereit und liefert somit den notwendigen Strom. Das Gate des Treibertransistors 421 ist am Drain des Aktivierungstransistors 411 angeschlossen. Der Sourceanschluss des Treibertransistors 421 ist an die Versorgungsspannung 430 und der Drainanschluss an das Photolumineszenzanzeigeelement (PQD) 400 angeschlossen. Ein Speicherkondensator 422 liegt über Gate und Source des Transistors 421.

Die Funktion der Schaltung entspricht dem Funktionsprinzip der Schaltung in Fig. 5. Auch die schematischen Spannungspegel der Fig. 9 kommen zur Anwendung. Die angegebenen Spannungen beziehen auf den Versorgungsspannungsanschluß 430. An den Versorgungsspannungsanschluß 430 werden 0 Volt angelegt.

Beim Anliegen einer negativen Spannung am Kathodenanschluss des PQD 440 wird bei einem Zeilenabtastvorgang durch das Anlegen einer negativen Spannung an die Aktivierungsleitung 460 und einen dadurch leitend werdenden Aktivierungstransistor 411 beim Anliegen einer negativen Datenspannung an der Datenleitung 450 der Treibertransistor 421 leitend und somit dazu veranlasst, eine positive Spannung (zwischen Anode und Kathode) für eine Emission des PQD 400 bereitzustellen und diese als helles Pixel erscheinen zu lassen. Liegt anstelle der negativen Spannung eine "Null"-Spannung an der Datenleitung 450 während des Abtastvorgangs an, bleibt der Treibertransistor gesperrt und es werden Null Volt am PQD 400 (zwischen Anode und Kathode) bereitgestellt. Daher erscheint das PQD als ein dunkles Pixel.
Wird der Aktivierungstransistor 411 durch das Anlegen einer "Null"-Spannung deaktiviert, d.h. gesperrt, bleibt die Spannung am PQD, unabhängig von der Spannung an der Datenleitung 450 bis zum nächsten Zeilenabtastvorgang konstant. Dies wird dadurch realisiert, dass ein Kondensator 422 die Gate-Source-Spannung des Transistors 421 bis zum nächsten Zeilenabtastvorgang speichert und somit den Zustand des Treibertransistors 421 konstant hält. Für den emissiven Betrieb muss daher die Aktivierungsleitungsspannung kleiner als die Summe aus Datenspannung und Schwellenspannung des Transistors 411 sein, wobei die Datenspannung kleiner als die Schwellenspannung des Transistors 421 sein muss.

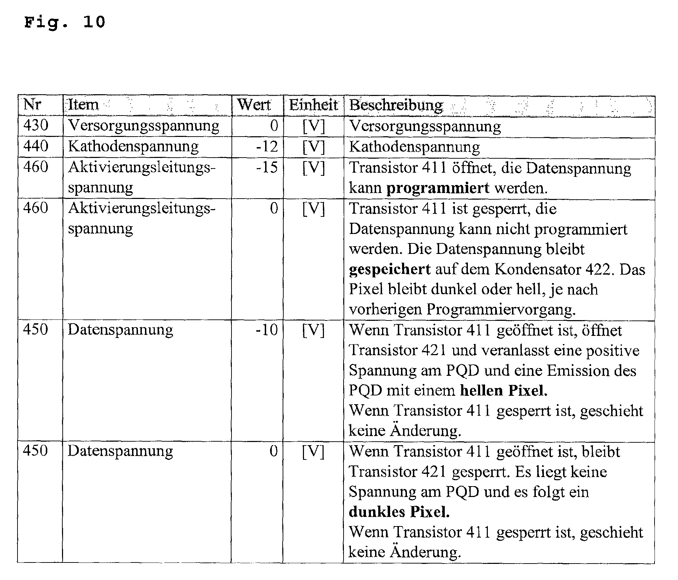

Die in Fig. 10 dargestellte Tabelle fasst die Funktion des emissiven Betriebs zusammen und zeigt die verwendeten Spannungen bei Verwendung von selbstsperrenden p-Kanal Dünnfilm-Polysilizium-Feldeffekttransistoren mit einer Schwellenspannung von ca.-2,5V.

Der remissive Betrieb setzt das Vorhandensein von für die Photolumineszenz notwendigem Umgebungslicht voraus. Beim Anliegen einer positiven Spannung am Kathodenanschluss 440 wird bei einem Zeilenabtastvorgang durch das Anlegen einer "Null"-Spannung an die Aktivierungsleitung 460 und einen dadurch leitend werdenden Aktivierungstransistor 411 beim Anliegen einer "Null"-Datenspannung an der Datenleitung 450 der Treibertransistor 421 leitend und somit dazu veranlasst, eine negative Spannung (zwischen Anode und Kathode) für eine Photolumineszenzlöschung für das PQD 400 bereitzustellen und diese somit als dunkles Pixel erscheinen zu lassen. Liegt anstelle der "Null"-Spannung eine positive Spannung an der Datenleitung 450 während des Abtastvorgangs an, bleibt der Treibertransistor gesperrt und es werden Null Volt am PQD 400 (zwischen Anode und Kathode) bereitgestellt. Diese erscheint als helles Pixel durch Photolumineszenz.
Wird der Aktivierungstransistor 411 durch das Anlegen einer positiven Spannung deaktiviert, dh. gesperrt, bleibt die Spannung am PQD, unabhängig von der Spannung an der Datenleitung 450 bis zum nächsten Zeilenabtastvorgang konstant. Dies wird dadurch realisiert, dass ein Kondensator 422 die Gate-Source-Spannung des Transistors 421 bis zum nächsten Zeilenabtastvorgang speichert und somit den Zustand des Treibertransistors 421 konstant hält. Für den reemissiven Betrieb muss daher die Aktivierungsleitungsspannung größer als die Datenspannung sein, welche wiederum größer als die Differenz aus Kathodenspannung und Schwellenspannung des Transistors 421 sein muss.

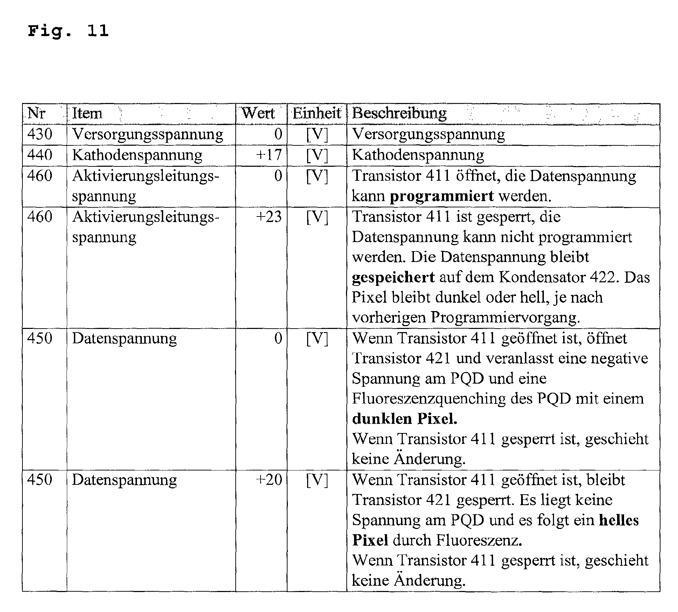

Die in Fig. 11 dargestellte Tabelle fasst die Funktion des reemissiven Betriebs zusammen und zeigt die verwendeten Spannungen bei Verwendung von selbstsperrenden p-Kanal Dünnfilm-Polysilizium-Feldeffekttransistoren mit einer Schwellenspannung von ca.-2,5V.

Die Erfindung ist nicht beschränkt auf die hier dargestellten Ausführungsbeispiele, vielmehr ist es möglich, durch Kombination und Modifikation der genannten Mittel und Merkmale weitere Ausführungsvarianten zu realisieren, ohne den Rahmen der Erfindung zu verlassen.

### Bezugszeichenliste

- 1: Kathode mit Isolatorschichten zur Injektionsverbesserung
- 2: Anode
- 3: Lochinjektionsschicht
- 3a: Injektion von Löchern
- 3b: Extraktion von Löchern
- 4: Emitterschicht
- 4a: Injektion von Elektronen
- 4b: Extraktion von Elektronen
- 5: einfallendes Anregungslicht
- 5a: Rekombination zum angeregten Zustand
- 5b: Bildung von angeregten Zuständen durch einfallendes Licht
- 6: transparentes Substrat
- 6a: Strahlende Rekombination des angeregten Zustandes unter Lichtaussendung oder Dissoziation im elektrischen Feld
- 7: reemittierte Photolumineszenzstrahlung
- 7a: Austretendes Elektrolumineszenzlicht
- 7b: Austretendes Photolumineszenzlicht
- 200: PQD
- 201: schematisches Spannungspegeldiagramm am PQD zwischen Anode und Kathode
- 215: elektronische Ansteuerschaltung
- 230: Versorgungsspannung
- 240: Kathodenanschluss des PQD
- 250,250a, 250b,250c: Datenleitung
- 260,260a, 260b,260c: Aktivierungsleitung
- 300: PQD
- 301: schematisches Spannungspegeldiagramm am PQD zwischen Anode und Kathode
- 310: Aktivierungsschaltung
- 320: Treiberschaltung
- 330: Versorgungsspannung
- 340: Kathodenanschluss des PQD
- 341: schematisches Spannungspegeldiagramm am Kathodenanschluss des PQD
- 350: Datenleitung
- 351: schematisches Spannungspegeldiagramm an der Datenleitung
- 360: Aktivierungsleitung
- 361: schematisches Spannungspegeldiagramm an der Aktivierungsleitung
- 400: PQD
- 411: Aktivierungstransistor
- 421: Treibertransistor
- 422: Speicherkondensator
- 430: Vorsorgungsspannung
- 440: Kathodenanschluss des PQD
- 450: Datenleitung
- 460: Aktivierungsleitung
- 500: Matrix aus PQD
- 510: Displaysubstrat
- 520: interne Aktivierungs-/Zeilentreiberschaltung
- 530: interne Daten-/Spaltentreiberschaltung
- 600: Matrix aus PQD
- 610: Displaysubstrat
- 620: externe Aktivierungs-/Zeilentreiberschaltung
- 630: externe Daten-/Spaltentreiberschaltung

## Patentansprüche

1. Verfahren zur Ansteuerung eines Aktiv-Matrix-Displays aus Photolumineszenz-Löschungs-Elementen (PQD), wobei die PQD sowohl im emissiven Modus zur Umwandlung von Signalspannungen in Licht als auch im reemissiven Modus zur Unterdrückung einer Photolumineszenzemission schaltbar sind und die Graustufeninformationen für die Pixel in Form von Signalspannungen durch selektives Adressieren von Zeile und Spalte erzeugt werden, **dadurch gekennzeichnet, dass** eine Signalspannung oder ein Signalstrom im emissiven Modus eine Spannung und/oder einen Stromfluss in Durchlassrichtung des PQD und im reemissiven Modus eine Spannung in Sperrrichtung des PQD steuert und diese Spannung und/oder dieser Stromfluss bis zu einer nächsten selektiven Adressierung dieser Zeile und Spalte am PQD konstant gehalten wird.

2. Verfahren nach Anspruch 1, **dadurch gekennzeichnet, dass** für den emissiven Betrieb des PQD eine negative Kathodenspannung (340, 440) und für den reemissiven Betrieb des PQD eine positive Kathodenspannung (340, 440) bezogen auf den Versorgungsspannungsanschluss (330, 430) anliegt.

3. Verfahren nach Anspruch 1 oder 2, **dadurch gekennzeichnet, dass** für den emissiven Betrieb die Aktivierungsleitungsspannung (360, 460) kleiner ist als die Summe aus Datenspannung (350, 450) und Schwellenspannung des Aktivierungstransistors (411), wobei die Datenspannung (350, 450) kleiner ist als die Schwellenspannung des Treibertransistors (421) bezogen auf den Versorgungsspannungsanschluss (330, 430).

4. Verfahren nach Anspruch 1 oder 2, **dadurch gekennzeichnet, dass** für den reemissiven Betrieb die Aktivierungsleitungsspannung (360, 460) größer ist als die Datenspannung (350, 450) und diese größer ist als Differenz aus Kathodenspannung (340, 440) und Schwellenspannung des Treibertransistors (421) bezogen auf den Versorgungsspannungsanschluss (330, 430).

5. Verfahren nach Anspruch 2 bis 4, **dadurch gekennzeichnet, dass** am Versorgungsspannungsanschluss (330, 430) eine Spannung von Null Volt anliegt.

6. Verfahren nach Anspruch 1 bis 5, **dadurch gekennzeichnet, dass** das Bereitstellen der für den Anzeigenbetrieb notwendigen Datenspannungen und Aktivierungsspannungen sowohl durch externe elektronische Schaltungen als auch durch interne, auf dem Anzeigesubstrat befindliche elektronische Schaltungen realisiert werden kann.

7. Verfahren nach Anspruch 1 bis 6, **dadurch gekennzeichnet, dass** die zu steuernden PQD mit positiver Spannung zwischen Anode und Kathode zur Emission von Elektrolumineszenzlicht und mit negativer Spannung zwischen Anode und Kathode zur Unterdrückung von Photolumineszenzlicht durch Photolumineszenzlöschung schaltbar sind.

8. Ansteuerschaltung für ein Aktiv-Matrix-Display aus Photolumineszenz-Löschungs-Elementen (PQD), wobei die PQD sowohl im emissiven Modus zur Umwandlung von Signalspannungen in Licht als auch im reemissiven Modus zur Unterdrückung einer Photolumineszenzemission schaltbar sind und die Graustufeninformationen für die Pixel in Form von Signalspannungen durch selektives Adressieren von Zeile und Spalte erzeugt werden, bestehend aus zwei selbstsperrenden p-Kanal Dünnfilm-Polysilizium-Feldeffekttransistoren (411, 421) und einem Kondensator (422), wobei die Aktivierungsleitung (460) mit dem Gate des Aktivierungstransistors (411) und die Datenleitung mit der Source des Aktivierungstransistors (411) verbunden ist, das Gate des Treibertransistors (421) mit dem Drain des Aktivierungstransistors (411), die Source des Treibertransistors (421) mit dem Versorgungsspannungsanschluss (430) verbunden ist und das PQD mit dem Drain des Treibertransistors (421) und der Kathode (440) verbunden ist, wobei ein Speicherkondensator (422) über Gate und Source des Treibertransistors (421) liegt.

9. Ansteuerschaltung nach Anspruch 8, **dadurch gekennzeichnet, dass** für den emissiven Betrieb des PQD eine negative Kathodenspannung (340, 440) und für den reemissiven Betrieb des PQD eine positive Kathodenspannung (340, 440) bezogen auf den Versorgungsspannungsanschluss (330, 430) anliegt.

10. Ansteuerschaltung nach Anspruch 8, **dadurch gekennzeichnet, dass** im emissiven Betrieb die Aktivierungsleitungsspannung (360, 460) kleiner ist als die Summe aus Datenspannung (350, 450) und Schwellenspannung des Aktivierungstransistors (411), wobei die Datenspannung (350, 450) kleiner ist als die Schwellenspannung des Treibertransistors (421) bezogen auf den Versorgungsspannungsanschluss (330, 430) und im reemissiven Betrieb die Aktivierungsleitungsspannung (360, 460) größer ist als die Datenspannung (350, 450) und diese größer ist als Differenz aus Kathodenspannung (340, 440) und Schwellenspannung des Treibertransistors (421) bezogen auf den Versorgungsspannungsanschluss (330, 430).

11. Ansteuerschaltung nach Anspruch 9 bis 10, **dadurch gekennzeichnet, dass** am Versorgungsspannungsansch4luss (330) eine Spannung von Null Volt anliegt.

12. Ansteuerschaltung nach Anspruch 8 bis 11, **dadurch gekennzeichnet, dass** diese zusätzlich externe Aktivierungs-/Zeilentreiberschaltungenen oder externe Daten-/Spaltentreiberschaltungen aufweist.

13. Ansteuerschaltung nach Anspruch 8 bis 11, **dadurch gekennzeichnet, dass** diese zusätzlich interne Aktivierungs-/Zeilentreiberschaltungen oder intern Daten-/Spaltentreiberschaltungen aufweist.
